# EUROPEAN PATENT APPLICATION

(11) **EP 3 214 453 A1**
(43) Date of publication of application: **06.09.2017**
(21) Application number: 16158474.3
(22) Date of filing: 03.03.2016
(51) Int. Cl.: G01R 31/12, H02H 1/00, H01H 9/50

(54) **METHOD AND APPARATUS FOR ARC FAULT DETECTION IN ELECTRICAL SYSTEMS**

(71) Applicant: ABB Schweiz AG, 5400 Baden (CH)
(72) Inventor: CHINE, Luigi, 10078 Venaria Reale (TO) (IT); BORGOGNI, Marco, 52027 San Giovanni Valdarno (AR) (IT); MIRRA, Mirco, 52028 Terranuova Bracciolini (AR) (IT)
(74) Representative: Mannucci, Michele

(57) **Abstract**

An apparatus (9) for detecting an electrical arc fault in an electrical system (1), is disclosed. The apparatus comprises an interface (13) configured for receiving data on operation of the electrical system and a processing unit (15) configured to: perform a time-domain analysis of the data; if at least one time-domain parameter of the data meets a potential arc fault condition, enabling the detection of an arc fault event based on a frequency-domain analysis of the data.

## Description

### Technical field

The disclosure generally relates to methods and apparatus for detecting arc faults in an electrical system. Embodiments disclosed herein concern methods and apparatus for arc fault detection in photovoltaic DC installations. Some embodiments specifically refer to methods and systems for reducing false arc fault detections in an arc fault detection arrangement.

### Background art

Several electrical systems can be subject to arc faults. These can occur for instance over high voltage DC lines, where a breakdown in wiring or in the electrical connectors occurs. These arcs can electrify the installation and cause serious damages. Typical electrical systems where arcs can develop are photovoltaic (solar) panel installations, among others. Arc faults can also cause fires that damage the electrical equipment and/or cause extensive property damages.

To address these safety issues, the solar industry has developed specific safety standards, such as the UL1699B Photovoltaic Arc-Fault Circuit Protection Standards and UL 1699 Arc Fault Interruption Specification. These standards define the requirements for systems with a DC bus voltage equal to or greater than 80V but less than 1kV. These safety standards require, inter alia, that an arc detection system be present, which is tripped when an arcing occurs. The arc detection system interrupts the operation of the electrical system in case of arc detection and is usually coupled with an annunciator, which indicates that the detection system has been tripped by an arc event. The annunciator can take a number of different forms, such as an optical signal generator, e.g. a LED, or an acoustic signal generator, such as a buzzer or a siren.

Detecting arcs in electrical systems, such as photovoltaic panel systems, is problematic for a variety of reasons. Arc detection is based on the analysis of electrical data from the system. Some arc fault detectors of the current art are based on a time-domain analysis of data from the electrical system being monitored. These detectors use for instance the waveform of the AC component of the current flowing in a high-voltage line and, based on the behavior of the waveform, determine if an arc fault occurs. Some known arc fault detection methods based on time-domain analysis detect a drop in the sensed current or other properties caused by an arc in the electrical system.

Other arc fault detectors of the current art are based on a frequency-domain analysis of the data from the electrical system being monitored. These systems are mainly based on analyzing the spectral content of the sensed current. Several post elaboration can be performed on the spectral content, to assess if an electrical arcing event occurs. This kind of analysis is based on the different spectral content of the sensed current in normal operating conditions and in the event of an arc, respectively. Exemplary embodiments of frequency-domain analysis systems for arc fault detection are disclosed in US2012/0316804.

One of the difficulties encountered in arc fault detection is caused by the presence of a large amount of noise in the signals, which are used as an input for the arc fault detector. Noise can trigger false alarms, i.e. it can cause the arc detection system to trip and turn off the inverter of the photovoltaic installation, or other electrical system. The safety standards require that the system be manually reset when it has been tripped. This makes the cost of false arc detections a primary concern, especially for remotely located installations. In photovoltaic installations, false alarms cause loss of power production, due to the interruption of the process of converting solar power into useful electrical power.

Both frequency-domain based as well as time-domain based systems for detecting arcing events have demonstrated vulnerability and weakness in terms of distinguishing a real arc events from other noise sources.

A need therefore exists for more efficient and reliable arc fault detection techniques, which improves immunity to nuisance tripping.

### Summary of the invention

The disclosure provides a technique for efficient and reliable arc fault detection in an electrical system, which is less prone to false arc detection alarms.

According to a first aspect, a method is disclosed, which includes the following: receiving data on operation of the electrical system; performing a time-domain analysis of the data; if at least one time-domain parameter of the data meets a potential arc fault condition, enabling the detection of an arc fault event based on a frequency-domain analysis of the data. Conversely, if the time-domain parameter does not meet the potential arc fault condition, detection of an arc fault event based on the frequency-domain analysis is disabled or inhibited.

Enabling the detection of an arc fault event based on the frequency-domain analysis can include for instance applying a signal containing actual data on the operation of the electrical system to a frequency-domain analysis module. When the detection of the arc fault event based on the frequency-domain analysis is not enabled, a different signal, e.g. a mute signal, not containing actual information on the operation of the electrical signal, can be applied to the frequency-domain analysis module. In other embodiments, enabling the detection of an arc fault event based on the frequency-domain analysis can include enabling the frequency-domain analysis module, which is otherwise disabled. In yet further embodiments, a time-domain analysis and a frequency-domain analysis can be performed in parallel and the arc fault detection is enabled only if both analyses show that an arc fault may be present in the electrical system.

More in particular, according to some embodiments the method can include inhibiting the frequency-domain analysis of the data if the time-domain analysis does not result in the potential arc fault condition being met. In this case, no frequency-domain analysis is performed at all. Inhibition can be obtained by preventing the data on operation of the electrical system from being processed by a frequency-domain analysis module.

For instance, a false arc fault detection signal is prevented from ensuing by forcing the input signal of a frequency-domain analysis module to a known value, e.g. to ground. In such case a frequency-domain analysis is performed continuously, also when the potential arc fault condition is not met. However the signal whereon the frequency-domain analysis is performed is not the actual signal containing the data on the electrical system operation, but rather a known signal, the spectral content whereof is certainly below an arc fault detection threshold. In further embodiments, the data flow to the frequency-domain analysis module can be selectively enabled or disabled.

In other embodiments, the method can include performing the frequency-domain analysis anyway, irrespective of whether the potential arc fault condition in the time-domain is met or not. In this case, what is prevented is the generation of a false arc detections signal, only, i.e. the frequency-analysis may result in a false arc detection, but no arc fault signal ensues, since the potential arc fault condition is not met.

A potential arc fault condition as understood herein is a condition which arises when an arc fault occurs in the electrical system, but the appearance whereof may also be related to other factors, not involving an arc fault. If such potential arc fault condition is detected on the basis of the time-domain analysis of the data, the frequency-domain analysis of the data is used to generate an arc detection signal. Such arc detection signal is generated only if the frequency-domain analysis of the data suggests that an arc fault is present. If the potential arc fault condition is not detected based upon the time-domain analysis, i.e. if the time-domain analysis does not detect a potential arc fault risk, generation of an arc fault detection signal based upon frequency-domain analysis is prevented. If the time-domain parameter is caused to meet the potential arc fault condition due to an event different from an arc fault occurring in the electrical signal, a false arc fault alarm is prevented by the subsequent frequency-domain analysis of the data.

The method is thus able to detect whether several conditions, rather than just one, are present, to assess that an arc fault is occurring. This results in a more robust and reliable detection of true arc faults, reducing false alarms.

The method disclosed herein is based on the recognition that an arc fault ignition is always accompanied by a notable increase in the current amplitude, particularly in the alternate component (AC), and by an alteration of the spectrum of the electrical waveform in the frequency domain. However, noise that can be present in the detected current signal does not have a significant effect on the amplitude of the detected current, while it may alter the spectral content of the detected signal in the frequency domain to such an extent as to generate a false arc fault detection signal.

Data on operation of the electrical system as understood herein can be any data, in analog or digital form, containing information on the operation of the electrical system. The data contain sufficient information in the time domain and in the frequency domain to perform a time-domain based and a frequency-domain based analysis to detect a possible arc fault in the electrical system. According to some embodiments, the data include information on the AC component of the current flowing in at least one section of the electrical system. For instance the data may be an analog or digital waveform representing a current flowing in at least a section of the electrical system, or the AC component of said current.

The data can be obtained from filtering the actual current flowing through the electrical system, such that only the data in a selected frequency range are used. Thus, current amplitude fluctuations in frequency ranges which are not relevant for arc detection purposes can be removed and will not be processed.

The time-domain parameter can be any parameter functionally related to the amplitude of the data, i.e. on the amplitude of the electric current. According to some embodiments, the time-domain parameter can be selected among the group consisting of: amplitude; like peak; peak-to-peak; root-square-mean value; quasi-peak; or a combination thereof; or an evaluation, for instance a statistical evaluation of one or more of said parameters over a certain time period.

The potential arc fault condition can be for instance a threshold of the amplitude-related time-domain parameter, here below also indicated as time-domain threshold.

The method disclosed herein thus provides for analyzing a sensed current signal both as time domain signature and frequency domain signature. If the sensed current signal does not exceed a certain amplitude threshold, which is indicative of an arc event, the frequency domain analysis on the sensed current is not performed, or the generation of an arc fault detection signal is inhibited. Only when the amplitude threshold is exceeded, the frequency domain analysis of the sensed current can result in an arc fault detection signal being generated, if the frequency domain analysis detects an alteration of the spectral content, which is indicative of an arc fault occurring in the electrical system.

It has been discovered that in this way nuisance tripping events, which are usually caused by noise in prior art systems based on frequency-domain analysis only, are avoided, or at least significantly reduced.

According to a further aspect, disclosed herein is an apparatus for detecting an electrical arc fault in an electrical system, comprising:
- an interface configured for receiving data on operation of the electrical system;
- and a processing unit configured to: perform a time-domain analysis of the data; if at least one time-domain parameter of the data meets a potential arc fault condition, enabling the detection of an arc fault event based on a frequency-domain analysis of the data.

Conversely, if the time-domain parameter does not meet the potential arc fault condition, arc fault detection based on the frequency-domain analysis is inhibited or disabled.

Additional features and advantages of the method and apparatus according to the present disclosure are set forth in the appended claims and will be described herein after, reference being made to exemplary embodiments thereof.

### Brief description of the drawings

A more complete appreciation of the disclosed embodiments of the invention and many of the attendant advantages thereof will be readily obtained as the same becomes better understood by reference to the following detailed description when considered in connection with the accompanying drawings, wherein:
Fig.1A illustrates a string topology photovoltaic array configuration according to a first embodiment;
Fig.1B illustrates a further embodiment of a photovoltaic array configuration;
Fig.1C illustrates a further embodiment of a photovoltaic array configuration;
Fig.2A illustrates a functional block diagram of an arc detection system according to an embodiment;
Fig.2B illustrates a functional block diagram of an arc detection system according to a further embodiment;
Figs.3A and 3B illustrate diagrams of embodiments of an arc detection system according to the present disclosure;
Fig.4 illustrates the band pass filter block and the time-domain analysis circuit of the system of Fig.3A in a possible embodiment;
Fig.5 illustrates a block diagram of a further embodiment of a system according to the present disclosure;
Figs. 6-10 illustrate example signals associated with arcing and non-arcing conditions in an electrical system.

### Detailed description of embodiments

The following detailed description of exemplary embodiments refers to the accompanying drawings. The same reference numbers in different drawings identify the same or similar elements. Additionally, the drawings are not necessarily drawn to scale. Also, the following detailed description does not limit the invention. Instead, the scope of the invention is defined by the appended claims.

Reference throughout the specification to "one embodiment" or "an embodiment" or "some embodiments" means that the particular feature, structure or characteristic described in connection with an embodiment is included in at least one embodiment of the subject matter disclosed. Thus, the appearance of the phrase "in one embodiment" or "in an embodiment" or "in some embodiments" in various places throughout the specification is not necessarily referring to the same embodiment(s). Further, the particular features, structures or characteristics may be combined in any suitable manner in one or more embodiments.

In the following description reference will be specifically made to arc fault detection in a photovoltaic installation. It shall however be understood that features disclosed herein can be used for designing an arc fault detector or arc fault circuit interrupter for any electrical system where similar safety issues and needs for high reliability of the arc detector arise.

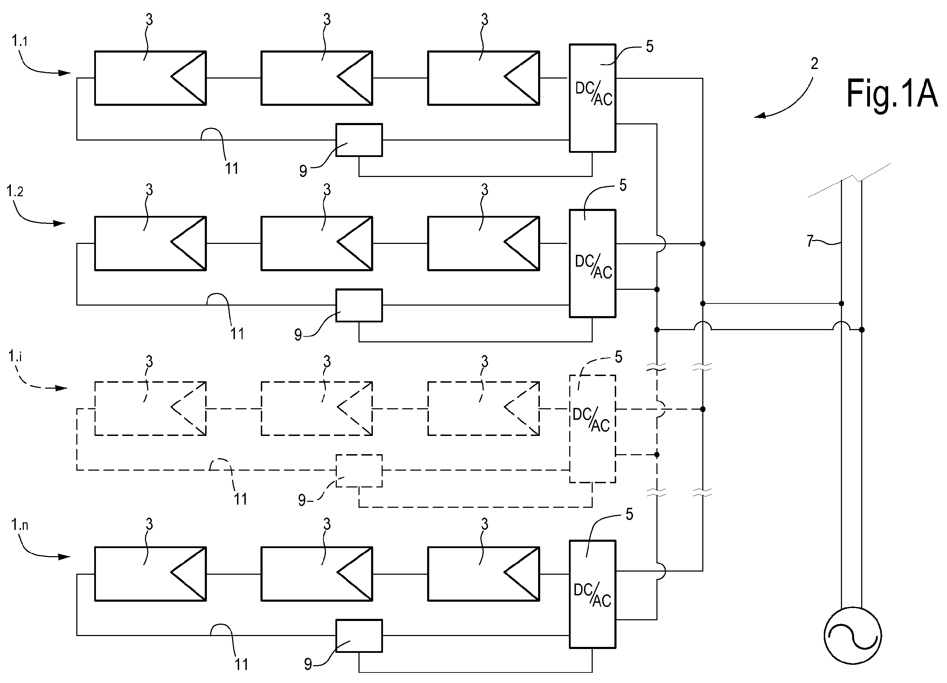

Fig.1A illustrates an exemplary embodiment of a central or string topology photovoltaic installation 2 comprised of a plurality of photovoltaic panel strings 1.1, 1.2, ... 1.n. Each string 1.1, ..1.n comprises a plurality of serially arranged photovoltaic panels 3 and an inverter 5. The inverter converts the DC electric power generated by the photovoltaic panels 3 into AC electric power, which is delivered to an electric power distribution grid 7.

Since several photovoltaic panels 3 are connected in series, each inverter typically carries 200-1000 V. Arc detection is required between each inverter 5 and the string of photovoltaic panels 3, whereto the inverter is connected. Each photovoltaic panel string 1.1, ...1.i, ... 1.n is thus provided with an arc fault detector (AFD) or arc fault circuit interrupter (AFCI) 9. The arc fault detector 9 is functionally connected to the electric line 11, which connects the photovoltaic panels 3 to the respective inverter 5.

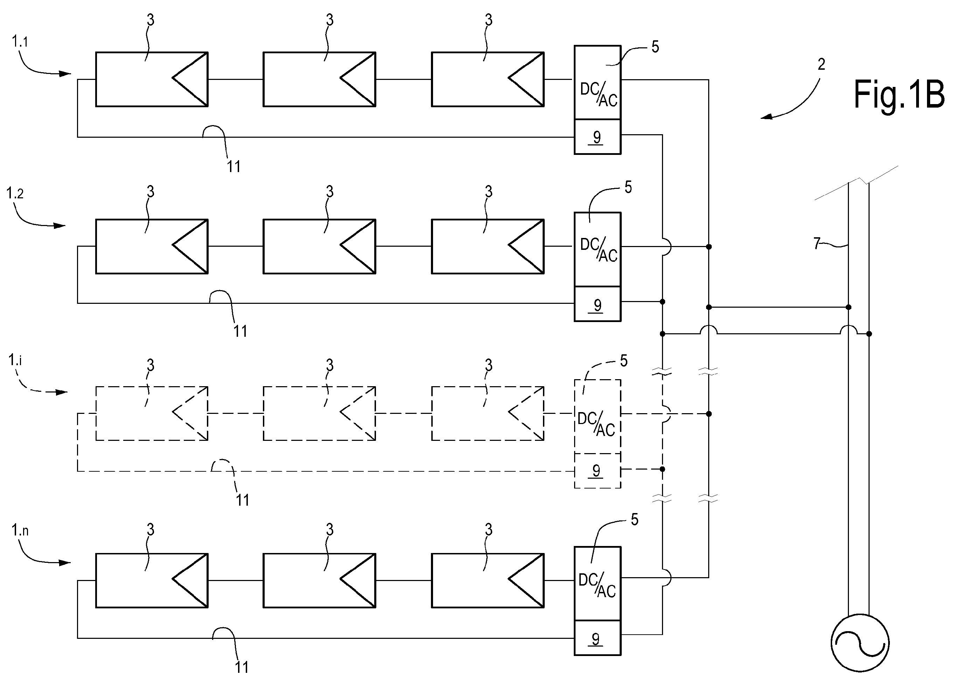

Fig.1B illustrates a modified embodiment of the photovoltaic array configuration. Differently from the embodiment of Fig.1A, in Fig.1B the arc fault detector 9 is integrated with the inverter 5.

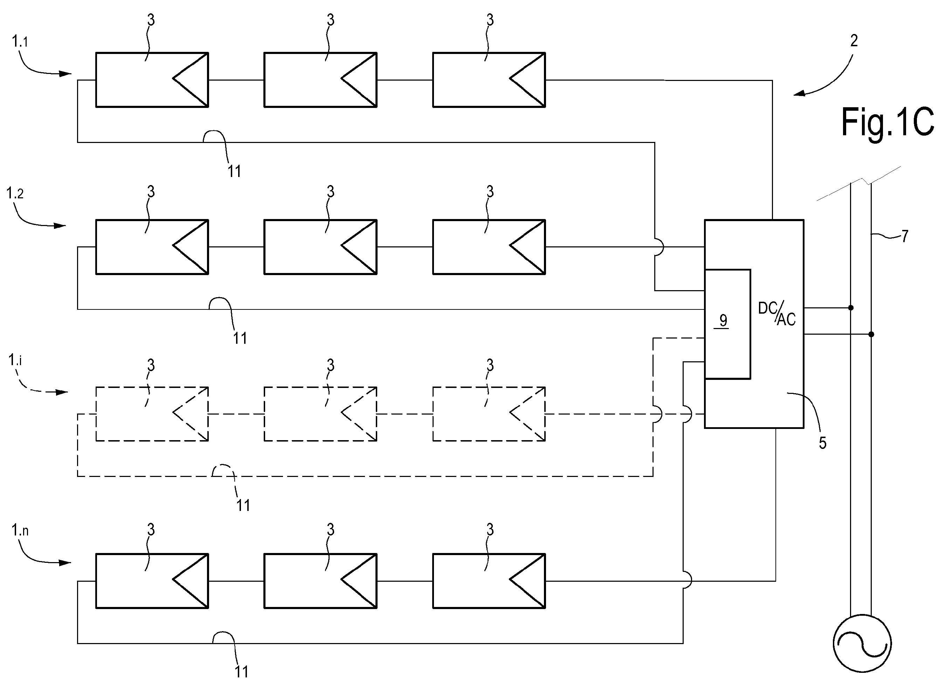

Fig. 1C illustrates a yet further embodiment of a photovoltaic array configuration. The same reference numbers designate the same or similar components as in Figs. 1A and 1B. In the embodiment of Fig. 1C the strings 1.1 .... 1.n are connected in parallel to a single inverter 5. An arc fault detector 9 is combined with or integrated into the inverter 5.

Irrespective of the configuration of the photovoltaic arrays and relevant inverter(s), the arc fault detector or each arc fault detector 9 can be configured as described here below.

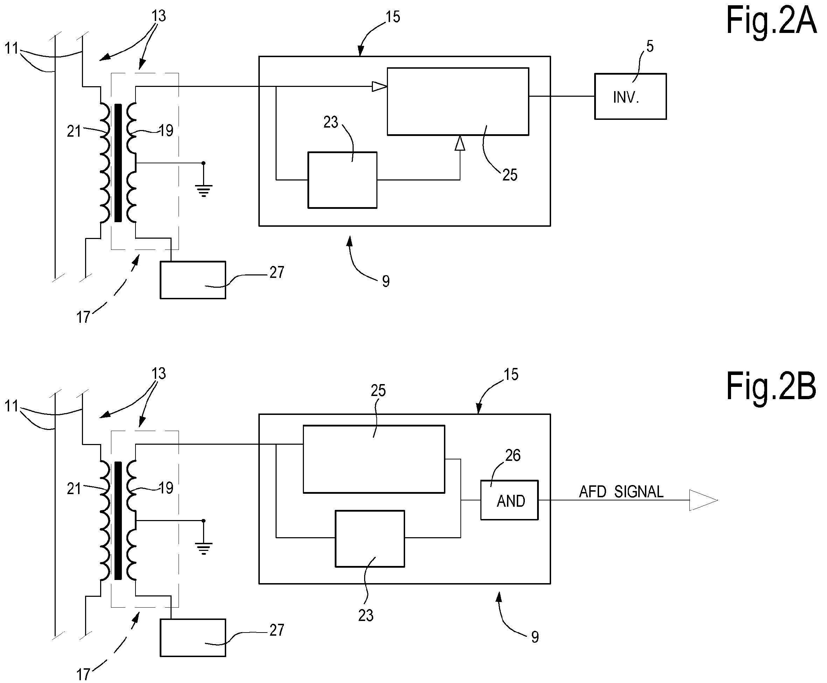

Fig.2A, with continuing reference to Figs.1A-1C, illustrates a block diagram of an arc fault detector 9 according to the present disclosure. The arc fault detector 9 can be comprised of an interface 13 and a processing unit 15. The interface 13 connects the processing unit 15 to the electric line 11 or to any section of the electrical system, whereto the arc fault detector 9 is associated. In some embodiments, the interface 13 can be comprised of a current sensor 17. In the exemplary embodiment of Fig. 2 the current sensor comprises a secondary winding 19 of a transformer. The string current, i.e. the total current generated by the serially arranged photovoltaic panels 3 connected to the electric line 11, flows through a primary winding 21 of the transformer. Thus, across the terminals of the secondary winding 19 an AC signal is present, which contains data on the operation of the electrical system comprised of the electric line 11, the photovoltaic panels string 1.i and the inverter 5. The signal containing the data on the operation of the electrical system is processed by the processing unit 15 as described hereafter, to detect whether an arc fault appears in the electrical system. If the arc fault detector 9 is configured and arranged as in Fig.1C, the signal contains data on the total current from all the strings of photovoltaic panels at the input of the single inverter 5.

In general terms, the processing unit 15 comprises a time-domain analysis module 23 and a frequency-domain analysis module 25. As will be apparent from the following description of exemplary embodiments of subject matter disclosed herein, the time-domain analysis module 23 and the frequency-domain analysis module 25 can be implemented by different combinations of software and hardware components. The same functions can in fact be implemented via software or via hardware. Some exemplary embodiments, based on different combinations of software and hardware implementations, will be described herein.

The time-domain analysis module 23 is configured for analyzing the AC signal from the current sensor 17 in the time domain, in order to detect a time domain signature, which can be indicative of an arc fault occurring in the electric system. According to some embodiments, the time-domain analysis module 23 can be configured for detecting the amplitude of the AC signal, or else to detect the peak of the AC signal. The frequency-domain analysis module 25 is, conversely, configured for analyzing the spectral content of the AC signal and determining a frequency domain signature indicative of an arc fault.

According to embodiments disclosed herein, the time-domain analysis module 23 and the frequency-domain analysis module 25 are combined to one another such that the frequency-domain analysis of the data on the operation of the electrical system, contained in the signal from the current sensor 17, is performed only if the time-domain analysis module 23 indicates that at least one time-domain parameter meets a potential arc fault condition. Alternatively, the time-domain analysis module 23 and the frequency-domain analysis module 25 can be arranged and configured such that an arc fault detection signal based on the frequency analysis ensues only if also the time-domain analysis results in the time-domain parameter meeting the potential arc fault condition.

In the embodiments disclosed here below the time-domain parameter is an amplitude-related parameter of the detected current, while the potential arc fault condition is a condition wherein the detected amplitude-related parameter exceeds a pre-set time-domain threshold. If the time-domain threshold is not exceeded, the frequency-domain analysis is not performed, and/or anyhow ensuing of an arc fault detection signal is prevented.

Only if the two conditions are met, namely that the time-domain parameter has met the potential arc fault condition (e.g. has exceeded the pre-set time-domain threshold) and the frequency domain analysis has determined a spectral content indicative of an arc fault, an arc fault detection signal will turn off the inverter 5.

A self-test circuit 27 can be connected to the secondary winding 19 of the transformer. The self-test circuit 27 can be configured in a manner known to those skilled in the art, and is aimed at producing a noise signal that can be controlled e.g. manually or by the processing unit 15. The noise signal simulates an arc fault and is used to periodically check if the arc fault detector 9 is properly operating.

A further embodiment of a functional block diagram of an arc fault detector 9 according to the present disclosure is shown in Fig. 2B. Components and blocks having the same function as previously disclosed in connection with Fig.2A are labeled with the same reference numbers. In the block diagram of Fig. 2B the time-domain analysis module 23 and the frequency-domain analysis module 25 are configured such that the frequency-domain analysis of the data on the operation of the electrical system and the time-domain analysis are performed in parallel and the result of the two analyses are combined in a functional "AND" block 26. The functional "AND" block 26 generates an arc fault detection signal (AFD signal) only if both the time-domain analysis and the frequency-domain analysis give a positive outcome, i.e. if the time-domain parameter meets a potential arc fault condition and the frequency-domain analysis indicates that the frequency content of the analyzed signal is indicative of an arc being present in the electrical system. If either one, the other or both the analyses performed by blocks 23 and 25 do not provide a result consistent with an arc fault being present, no AFD signal will ensue.

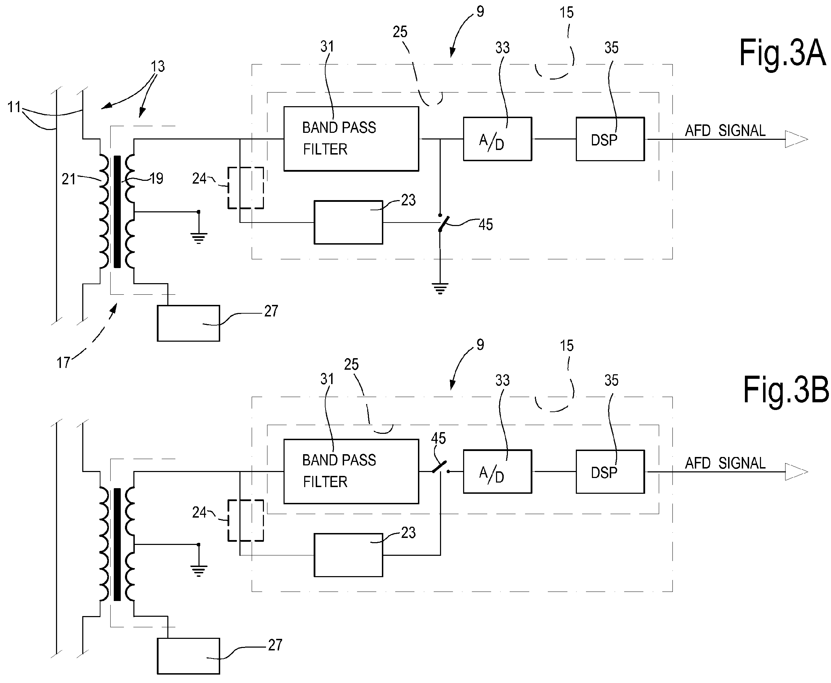

With continuing reference to Fig.2A, Fig.3A illustrates in more detail a block diagram of an arc fault detector 9 in a possible embodiment. The same reference numbers designate the same components as already disclosed in conjunction with Fig. 2A. According to the embodiment of Fig. 3A, the processing unit 15 comprises a band-pass filtering stage 31, an analog/digital converter 33 and a programmable control unit 35, e.g. a microcontroller or a digital signal processor. The AC signal containing the data on the operation of the electrical system 3, 11, 5 is filtered by the band-pass filtering stage 31 and is applied to the analog/digital converter 33, which samples and digitalizes the filtered signal from the band-pass filtering stage 31. The digitalized signal is applied to the programmable control unit or digital signal processor 35, which performs the frequency analysis of the digitalized signal.

The band-pass filtering stage 31, the analog/digital converter 33 and the programmable control unit 35 can form part of the frequency-domain analysis module 25. The programmable control unit 35 can be programmed to perform any suitable frequency-domain or spectral analysis of the sampled and digitalized signal. Algorithms for frequency analysis suitable for arc fault detection are known to those skilled in the art and will not be described in detail herein.

The pass band of the band-pass filtering stage 31 is selected such as to remove from the signal those frequencies, which are caused e.g. by switching of the inverter 5 or other noise possibly present in the signal, which is not connected to an arcing event. For instance the pass-band can be between about 40 kHz and about 200 kHz.

The time-domain analysis module 23 is arranged in parallel to the band-pass filtering stage 31. The time-domain analysis module 23 detects the value of a time parameter of the AC signal detected by the AC current sensor 17 and generates an enable or disable signal which selectively enables or disables the detection of an arc fault event based on the frequency analysis. In some exemplary embodiments, the time parameter is the peak of the detected AC current signal. The time-domain analysis module 23 in this case generates an enabling signal if the amplitude peak of the AC signal exceeds a first time-domain threshold. Conversely, if the peak of the amplitude of the AC signal does not exceeds the first time-domain threshold, the enabling signal is not generated and detection of an arc fault event based on the frequency analysis is inhibited. In the exemplary embodiment of Fig. 3A the enabling/disabling signal generated by the time-domain analysis module 23 is applied to a switch 45, which selectively connects the inlet of the analog/digital converter 33 to ground. The inlet signal applied to the analog/digital converter 33 becomes low if the switch 45 is closed. Conversely, if the switch 45 is open, the actual output signal of the band-pass filtering stage 31 is applied to the input of the analog/digital converter 33. Thus, in case the switch 45 is closed, no arc fault detection signal whatsoever can be generated on the basis of the frequency analysis, irrespective of the spectral content of the signal, and this de facto inhibits the generation of an arc fault detection signal.

Vice-versa, if the switch 45 is open, an arc fault detection signal is generated if the spectral content of the incoming current signal, as resulting from the frequency-domain analysis, is indicative of an arc fault being present in the electrical system.

In other embodiments, the enabling/disabling signal can be possibly applied directly to an inlet port of the programmable control unit 35, and control the operation thereof such that either the frequency-domain analysis is not executed or else the arc fault detection signal is prevented from ensuing.

According to some embodiments, an additional filtering block 24 can be provided, which is arranged upstream of the input of the time-domain analysis module 23, or form part thereof. The purpose of this additional filtering block 24 is to select one or more frequency ranges, such that the time-domain analysis is performed on a signal containing only selected frequency values.

Fig.3B illustrates another embodiment of the arc fault detector 9. The same reference numbers indicate the same or equivalent elements as disclosed in connection with Fig. 3A. The embodiment of Fig. 3B differs from the embodiment of Fig. 3A in that the switch 45 is arranged between the band-pass filtering stage 31 and the analog/digital converter 35. The switch 45 is again controlled by an enabling/disabling signal from the time-domain analysis module 23. In this embodiment, the time-domain analysis module 23 and the switch 45 are arranged and configured such that the switch 45 is closed if the time-domain analysis performed by block 23 results in the time-domain parameter meeting the arc fault condition. Otherwise, the switch 45 is open. The signal from the band-pass filtering stage 31 will thus be processed by the analog/digital converter 33 only if the time-domain analysis results in a positive arc detection condition.

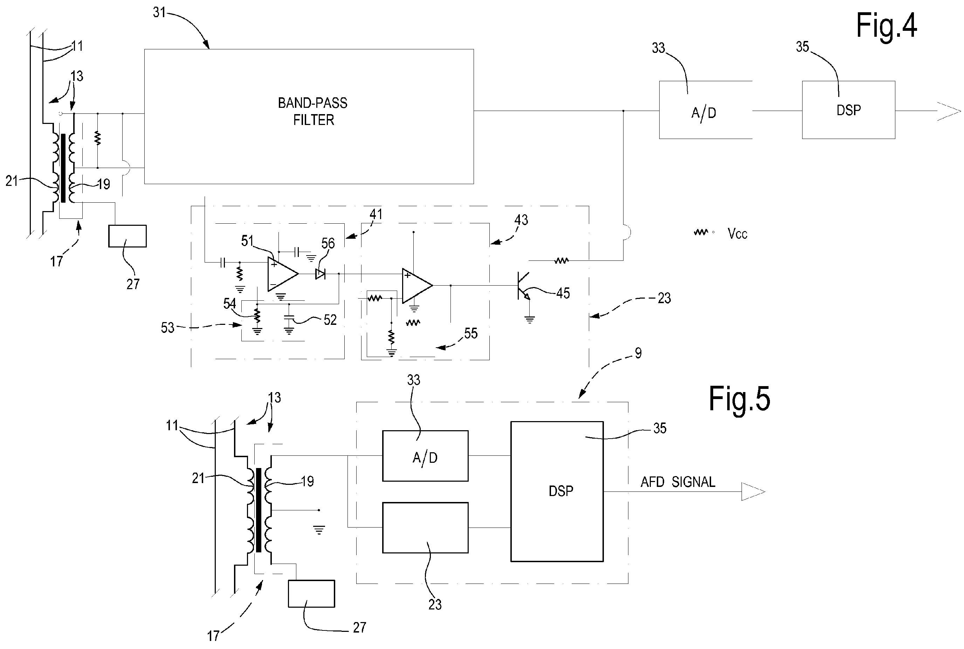

With continuing reference to Fig.3A and 3B, a more detailed diagram of an embodiment of the time-domain analysis module 23 is shown in Fig. 4.

The time-domain analysis module 23 can be comprised of a current amplitude evaluation block. The current amplitude evaluation block can be comprised of a peak detector 41. The time-domain analysis module 23 can further comprise a comparator 43 and an electronic switch 45, which is controlled by the output signal of comparator 43. In the exemplary embodiment of Fig. 4, the electronic switch 45 is connected between ground and the last stage of the band-pass filtering stage 31. If the switch 45 is closed, the signal at the input of the analog/digital converter 33 is kept low and the frequency-domain analysis is inhibited. As a matter of fact, the input signal of the frequency-domain analysis module 25 will be maintained at a low (ground) level, such that the spectral content thereof will always be below an arc detection threshold. The actual data contained in the signal from the band-pass filtering stage 31 do not reach the frequency domain analysis module 25.

Conversely, if the switch 45 is open, the frequency-domain analysis is executed by the frequency-domain analysis module 25 on the actual input signal from the band-pass filtering stage 31 containing the data on the operation of the electrical system. If the spectral content of the signal meets an arc fault detection condition, an arc fault detection signal will ensue.

Opening and closing of the switch 45 is controlled as follows. The peak detector 41 detects the peak value of the AC current signal from the current sensor 17. The output from peak detector 41 is applied to one of the input terminals of the comparator 43, while a reference value, representing a first time-domain threshold, is applied to the other input terminal of the comparator 43. If the peak value detected by the peak detector 41 is higher than the time-domain threshold, the output of the comparator 43 is low and the switch 45 is open such that the frequency domain analysis is normally executed on the signal coming from the current sensor 17, filtered by the band-pass filtering stage 31 and sampled and digitalized by the analog/digital converter 33. Conversely, if the peak value is lower than the first time-domain threshold, the output of the comparator 43 is high, the switch 45 is closed and frequency-analysis of the signal from the current sensor 17 is inhibited.

According to some embodiments, the peak detector 41 can be comprised of an operational amplifier 51 and a time-constant setting network, e.g. an RC network, comprising a capacitor 52 and a resistor 54, connected between the inverting input terminal and the cathode of a diode 56 arranged at the output terminal of the operational amplifier 51. The RC network 53 defines a time constant for the discharge of the peak detector output.

In the embodiment illustrated in Fig.4 the peak detector 41 is provided with a highpass filter 24, comprised of a capacitor and a resistor. In other embodiments a different filtering stage or a combined filtering stage can be provided, which may embody a band-pass or a notch filter, for selecting a frequency range only upon which the signal will be analyzed in the time-domain.

According to some embodiments, the comparator 43 can be provided with a resistor network 55, which defines a second time-domain threshold, lower than the first time-domain threshold. As soon as the peak detected by the peak detector exceeds the first time-domain threshold, the switch 45 is opened and the threshold applied to the inverting input terminal of the comparator 43 is lowered from the first time-domain threshold to the second time-domain threshold. The combination of the resistor network 55 and of the comparator 43 forms a comparator with hysteresis. The switch 45 will thus close again only once the output signal from the peak detector 41 becomes lower than the second, lower time-domain threshold. The use of a comparator with hysteresis, i.e. having a first and a second time-domain threshold guarantees that the frequency analysis is performed at least for the time interval that is necessary for the detection of an electrical arcing event.

The RC network 53 slows down the drop of the peak detector output. As long as the peak detector output stays higher than the second time-domain threshold, the output of comparator 43 remains low and the switch 45 remains open. The frequency-domain analysis is therefore enabled for a time interval which is determined by the hysteresis of the comparator, i.e. by the difference between the first and the second time-domain threshold, and by the time constant set by the RC network 53. The time interval during which the frequency domain analysis is performed by the control unit 35 is also a function of the amplitude of the sensed current. Choosing the value of the resistor and capacitor of the RC network allows to set the time interval appropriately. The higher the detected peak, the longer the frequency-domain analysis will be executed.

According to other embodiments, not shown, a peak detector which does not include an RC network can be used, in which case the time interval during which the frequency-domain analysis is performed, will be a fixed interval, rather than a variable one, dependent upon the detected peak value.

In yet further embodiments, a comparator with a single time-domain threshold, i.e. not having a hysteresis functionality, can be used.

As discussed in conjunction with Fig.3B, the output of the time-domain analysis module 23 of Fig.4 can be used to selectively opening and closing a switch arranged in series between the band-pass filtering stage 31 and the analog/digital converter 23, such that frequency-analysis will de facto be inhibited, unless the peak detector detects an amplitude that is higher than the first time-domain threshold and the second time-domain threshold (in case a comparator with hysteresis is used).

In the embodiment of Fig. 4 the band-pass function, as well as the peak detection and comparison between the peak value and the threshold(s) are performed by means of dedicated hardware circuitry. In other embodiments, some or all of these functions can be implemented via software. For instance, Fig. 5, with continuing reference to Figs. 2A and 2B, illustrates an embodiment wherein the AC current signal is sampled and converted into a digital signal by means of an analog/digital converter 33. The sampled and digitalized signal is then applied to the programmable control unit 35. Software executed by the programmable control unit 35 performs the band-pass filtering and frequency-domain analysis of the signal. The time-domain analysis module 23 can still include dedicated hardware circuitry, for instance comprising a peak detector 41 and a comparator 43. The peak detector is connected to the current sensor 17 and is arranged in parallel to the analog/digital converter 33. The output signal of the time-domain analysis module 23 can be applied to an input terminal of the programmable control unit 35 and is used by the software executed by the programmable control unit 35 to selectively inhibit or enable the frequency-domain analysis of the data on the operation of the electrical system, said data being contained in the sampled and digitalized signal at the output of the analog/digital converter 33.

In yet further embodiments, the entire functions of the time-domain analysis module 23 can be performed by software as well, rather than by dedicated hardware.

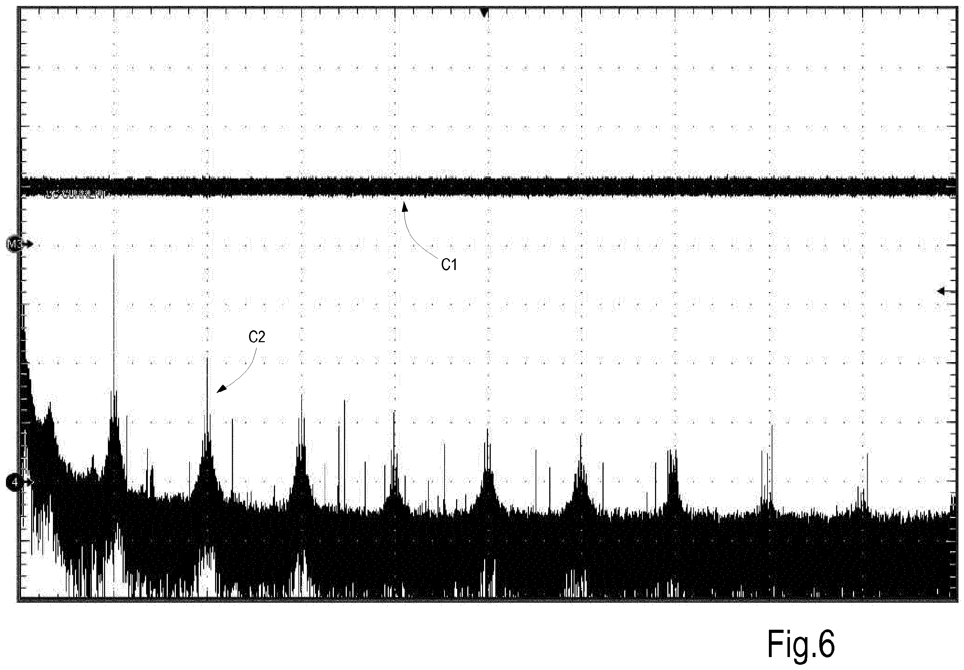

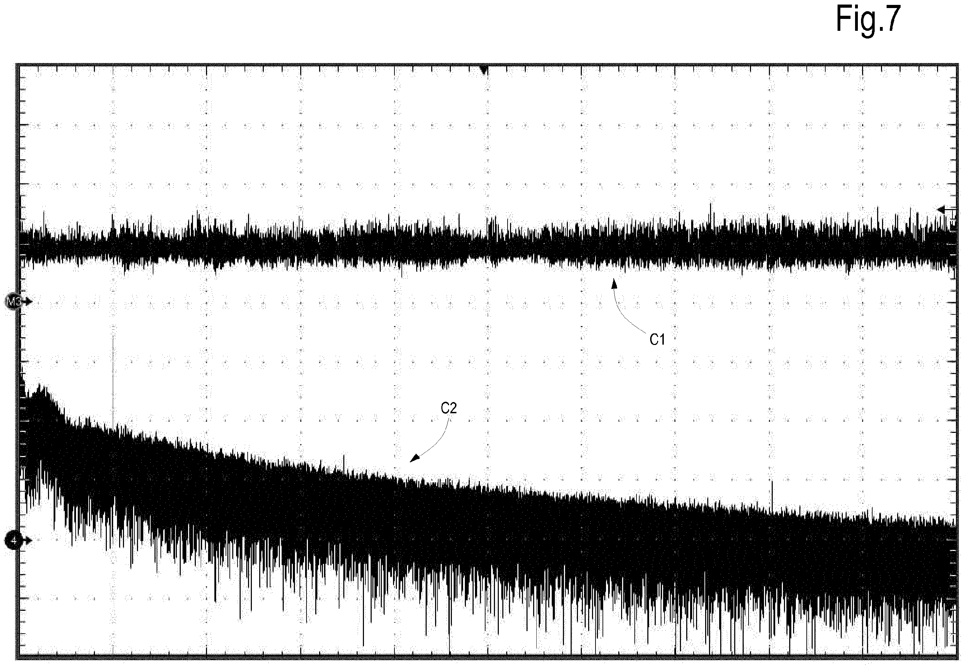

Figs. 6 and 7 illustrate the inverter input current in the time domain (curve C1) and in the frequency domain (curve C2). Fig.6 illustrates the conditions under normal operation of the electrical system, with no arc events occurring. Fig. 7 illustrates the same curves in the event of an arc occurring in the electrical system. By comparing Figs. 6 and 7, it can be appreciated that an arc fault causes an increase in the AC component of the current in the time domain, as well as a modification of the spectral content in the frequency domain.

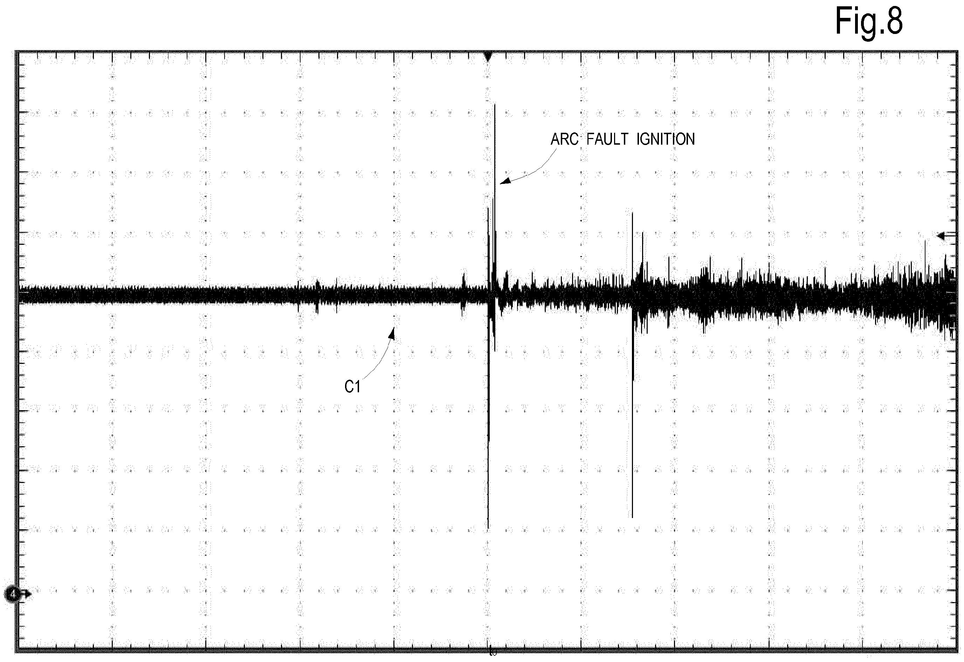

Fig.8 illustrates how the inverter input current waveform changes when an arc event occurs at instant t0 (time-domain representation). It can be appreciated from Fig. 8, that an arc fault is accompanied by an increase of the AC component of the inverter current, a strong current peak is detected at instant t0, followed by an anomalous fluctuation of the current intensity.

Figs. 7, 8 and 9 show that an arc fault is accompanied by an increase of the AC component in the current, which is detected by the current sensor 17.

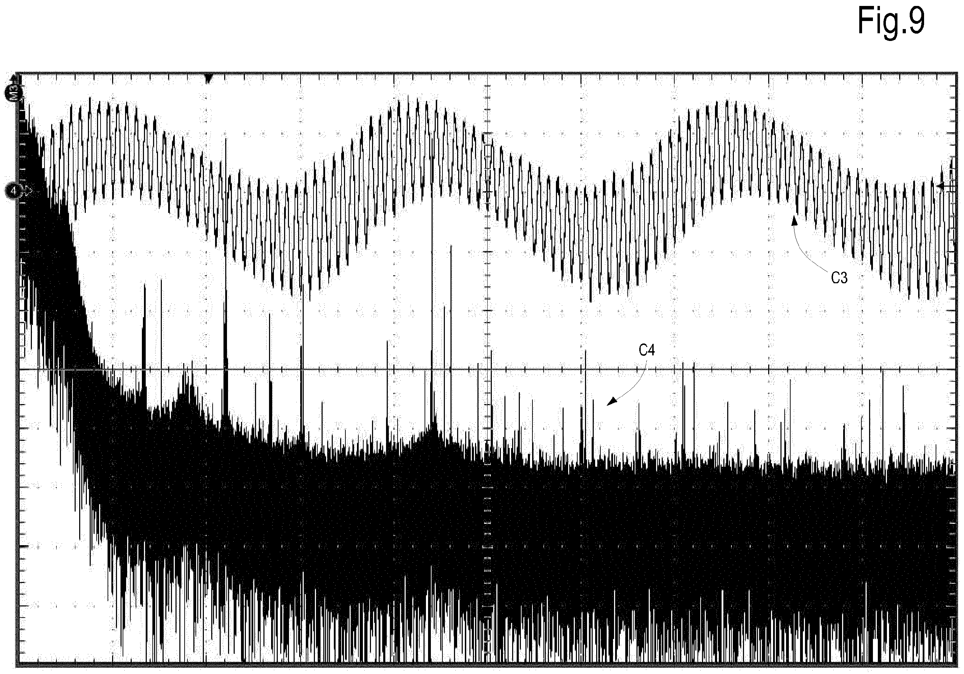

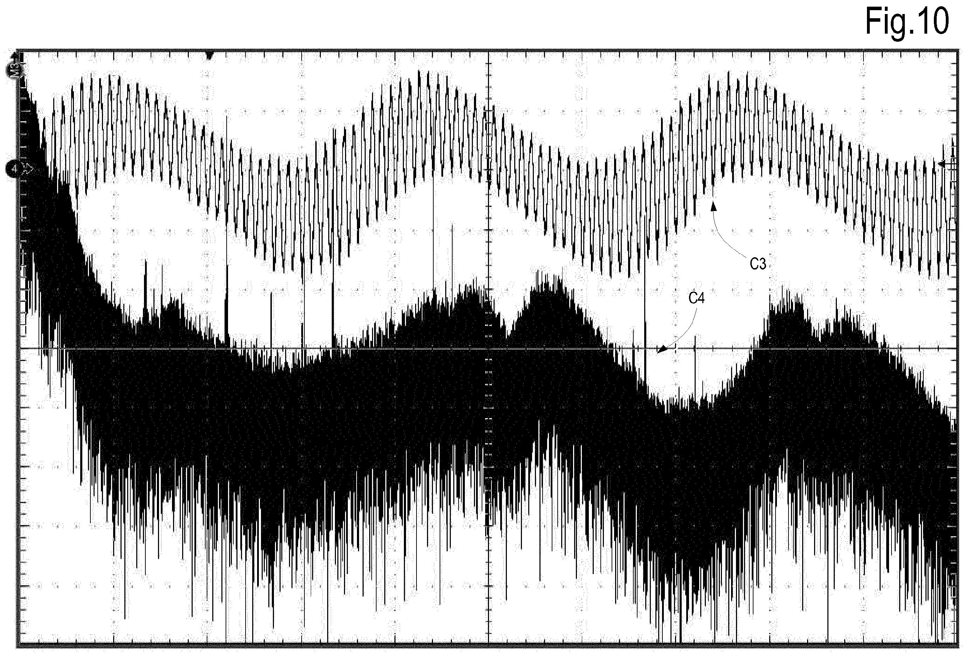

In Fig. 9. C3 represents the AC component of the inverter input current,. Curve C4 illustrates the spectral content of the AC component of the current in the frequency domain. Fig. 10 illustrates the same curves C3 and C4 in case of noise appearing in the current signal. The spectral content (curve C4) is altered and could lead to a false arc fault detection. It can however be appreciated that the noise on the current signal does not influence the amplitude of the current in the time domain (curve C3). Thus, in a situation as shown in Fig. 10, tripping of the inverter due to a false arc fault detection is avoided by the method and system disclosed herein, since the frequency domain analysis would be inhibited by the absence of an intensity peak overcoming the time-domain threshold.

## Claims

1. A method for detecting an electrical arc fault in an electrical system, comprising:
- receiving data on operation of the electrical system;
- performing a time-domain analysis of the data;
- if at least one time-domain parameter of the data meets a potential arc fault condition, enabling detection of an arc fault event based on a frequency-domain analysis of the data.

2. The method of claim 1, wherein meeting the potential arc fault condition includes exceeding a first time-domain threshold.

3. The method of claim 1 or 2, wherein the time-domain parameter is functionally related to an amplitude of a signal containing the data of the operation of the electrical system, and is preferably selected from the group consisting of: an amplitude; a like peak; a peak to peak; a root square mean value; a quasi-peak; or a combination thereof; or an evaluation thereof over a time period.

4. The method of one or more of the preceding claims, further comprising the step of sensing an AC component of a current flowing in at least a section of the electrical system.

5. The method of one or more of the preceding claims, further comprising the step of performing the frequency-domain analysis of the data for a time period dependent upon a value of the time-domain parameter.

6. The method of one or more of the preceding claims, further comprising the step of applying the time-domain parameter to a peak detector.

7. The method of one or more of the preceding claims, further comprising the steps of: applying the time-domain parameter to a first input of a comparator; applying a first time-domain threshold to a second input of the comparator; using an output signal of the comparator to enable the detection of an arc fault event based on the frequency domain analysis of the data.

8. The method of one or more of the preceding claims, further comprising the following step: if the time-domain parameter exceeds a first time-domain threshold, the frequency-domain analysis of the data is performed until the time-domain parameter remains above a second time-domain threshold, lower than the first time-domain threshold.

9. The method of one or more of the preceding claims, further comprising the step of band-pass filtering the data; wherein the frequency-domain analysis is performed on the data after band-pass filtering.

10. An apparatus for detecting an electrical arc fault in an electrical system, comprising:
- an interface configured for receiving data on operation of the electrical system;
- and a processing unit configured to: perform a time-domain analysis of the data; if at least one time-domain parameter of the data meets a potential arc fault condition, enabling the detection of an arc fault event based on a frequency-domain analysis of the data.

11. The apparatus of claim 10, wherein the processing unit comprises a band-pass filtering arrangement, configured and arranged for band-pass filtering said data, and wherein the processing unit is configured for performing the frequency-domain analysis on the filtered data.

12. The apparatus of claim 10 or 11, wherein the processing unit comprises a time-domain analysis module, whereto the data on the operation of the electrical system are applied, and configured for extracting a time-domain information from said data.

13. The apparatus of one or more of claims 10 to 12, wherein the processing unit is configured for performing the frequency-domain analysis of the data for a time period dependent upon a value of the time-domain parameter.

14. The apparatus of one or more of claims 10 to 13, comprising a current sensor configured for sensing an AC component of a current flowing in the electrical system.

15. The apparatus of claim 14, wherein the processing unit comprises a current amplitude evaluation block, configured for detecting an amplitude-related parameter of the sensed AC component, said amplitude-related parameter being the time-domain parameter.

16. The apparatus of claim 15, wherein the current amplitude evaluation block comprises a time-constant network, defining a time constant of discharging of the current amplitude evaluation block.

17. The apparatus of one or more of claims 10 to 16, wherein the processing unit comprises a comparator, having a first input terminal and a second input terminal, wherein the first input terminal is configured for receiving the time-domain parameter and the second input terminal is configured for receiving a time-domain threshold; and wherein an output of the comparator provides a signal for enabling detection of an arc fault event based on the frequency domain analysis of the data.

18. The apparatus of claim 17, wherein the comparator is a comparator with hysteresis, configured such that: if the time-domain parameter exceeds a first time-domain threshold, the frequency-domain analysis of the data is performed until the time-domain parameter remains above a second time-domain threshold, lower than the first time-domain threshold.
